# EUROPÄISCHE PATENTSCHRIFT

(11) **EP 2 597 670 B1**
(45) Veröffentlichungstag und Bekanntmachung des Hinweises auf die Patenterteilung: **30.03.2016**
(21) Anmeldenummer: 13154881.0
(22) Anmeldetag: 31.03.2010
(51) Int. Cl.: H01L 21/60, H01L 25/065, H01L 25/00

(54) **Verfahren zum permanenten Verbinden zweier Metalloberflächen**
Method for permanently connecting two metal surfaces
Procédé de liaison permanente de deux surfaces métalliques

(43) Veröffentlichungstag der Anmeldung: 29.05.2013
(62) Teilanmeldung aus: 10003568.2
(73) Patentinhaber: EV Group E. Thallner GmbH, 4782 St. Florian am Inn (AT)
(72) Erfinder: Wimplinger, Markus, 4910 Ried im Innkreis (AT); Dragoi, Viorel, 4782 St. Florian/Inn (AT)
(74) Vertreter: Schweiger, Johannes

(56) Entgegenhaltungen:
- EP-A1- 1 748 480
- WO-A1-03/072288
- GB-A- 2 300 375
- US-A1- 2003 201 532
- US-A1- 2006 292 824
- US-A1- 2009 108 421
- US-A1- 2009 134 501

## Beschreibung

Die Erfindung betrifft ein Verfahren gemäß Anspruch 1 zur Herstellung einer permanenten Verbindung zwischen zwei Metalloberflächen.

Das Herstellen von permanenten, elektrisch leitfähigen, metallischen Verbindungen zwischen zwei Metalloberflächen gewinnt in der Halbleiterindustrie zunehmend an Bedeutung. Das Dokument EP 1 748 480 A1 zeigt beispielsweise eine solche Verbindung.

Vor allem für neuartige Packaging Technologien im Bereich der sogenannten "3D Integrated Devices oder ICs (3D IC)" spielen metallische Bond Verbindungen zwischen zwei funktionalen Ebenen eine entscheidende Rolle. Dabei werden zunächst aktive oder passive Schaltkreise auf zwei unabhängigen Substraten gefertigt, und diese in einem Bonding Schritt permanent miteinander verbunden, sowie die elektrischen Kontakte etabliert. Dieser Verbindungsschritt kann entweder mittels Verbinden zweier Wafer (Wafer to Wafer - W2W), Verbinden eines oder mehrerer Chips mit einem Wafer (Chip to Wafer - C2W) oder dem Verbinden von einem oder mehrerer Chips mit einem Chip (Chip to Chip - C2C) Verfahren passieren. Bei diesen Verbindungsverfahren finden direkte Verbindungen zwischen zwei Verbindungsflächen, wobei beide Flächen weitgehend aus demselben Material (Metall) bestehen, großes Interesse. Ganz besonders bevorzugt sind dabei Verfahren, die weitgehend ohne zusätzliche Materialien in dieser Verbindungsebene auskommen. Häufig wird hierbei Kupfer (Cu) oder Aluminium (Al) oder Gold (Au) als Metallisierung verwendet. Es soll aber klargestellt sein, dass die vorliegende Erfindung grundsätzlich auch im Zusammenspiel mit anderen Metallen funktioniert, und die Metallwahl vorwiegend auf Erfordernissen der Chipstrukturen und Vorbearbeitungsschritten basiert. Es sollen daher auch andere Metalle als für die Erfindung in Anspruch genommen gelten. Weiterhin kann das Verfahren auch auf sogenannte "Hybrid Bond Interfaces" angewandt werden. Diese Hybrid Interfaces bestehen aus einer geeigneten Kombination von metallischen Kontaktflächen, die von nicht metallischen Regionen umgeben sind. Die nichtmetallischen Regionen sind dabei so gestaltet, dass in einem einzelnen Verbondungsschritt sowohl der metallische Kontakt, als auch Kontakte zwischen den nichtmetallischen Regionen hergestellt werden können. Derzeit werden diese Verbindungen, welche frei von Fremdmaterial, insbesondere von Fremdmetallen sind durch sogenannte Diffusionsbond Verfahren hergestellt. Dabei werden die Kontaktflächen zueinander ausgerichtet und in Kontakt gebracht. Die Kontaktflächen werden mittels geeigneter Verfahren (zum Beispiel "Chemical Mechanical Polishing" oder kurz "CMP") derart vorbehandelt, dass sie sehr eben sind, und eine geringe Oberflächenrauigkeit aufweisen. Die Kontaktflächen werden dann in einem geeigneten Gerät (zum Beispiel einem Wafer Bonder) zusammengepresst und gleichzeitig auf eine frei wählbare Prozesstemperatur geheizt. Es kann sich hier auch als vorteilhaft erweisen, wenn dies in einer optimierten Atmosphäre wie zum Beispiel Vakuum (z.B. <1mbar, bevorzugt <1e-3 mbar) oder in einer reduzierenden Atmosphäre, insbesondere eine Atmosphäre mit einem hohen Gehalt (>1%, bevorzugt >3%, noch besser >5% und idealerweise >9%) an Wasserstoff (H2) geschieht. Unter diesen Prozessbedingungen entsteht nun ein sogenannter Diffusionsbond zwischen den beiden Metalloberflächen. Dabei diffundieren Metallatome oder Moleküle im Falle von eutektischen Metallkompositionen zwischen den beiden Oberflächen hin und her und etablieren damit eine permanente, metallisch leitende und mechanisch äußerst stabile Verbindung zwischen den Oberflächen. Häufig ist die Verbindung dabei von einer Qualität, die einen Nachweis der ursprünglichen Kontaktflächen im Metallgefüge unmöglich macht. Vielmehr zeigt sich die Verbindung als homogene Metallstruktur, die sich nun über die ursprüngliche Kontaktfläche hinaus erstreckt. Ein Faktor, der den Einsatz dieser Technologie heute stark begrenzt, ist die zumeist relativ hohe Temperatur, welche notwendig ist, um die Verbindung herzustellen und insbesondere die Diffusion zu ermöglichen. In vielen Fällen ist diese Temperatur höher als 300°C, in vielen Fällen höher als 350°C, typischerweise 380 bis 400°C und in bestimmen Fällen auch bis zu 450 oder 500°C als die, von den Bauteilen tolerierbare Temperatur (typischerweise <260°C, vielfach <230°C, für bestimmte Bauteile <200°C und in bestimmten Fällen <180 oder sogar <150°C) und verhindert oder begrenzt daher den Einsatz dieses Verfahrens. Die vorliegende Erfindung umgeht nun dieses Problem, da sie ein Verfahren ermöglicht, bei dem die notwenige Prozesstemperatur dramatisch reduziert wird.

Diese metallischen Verbindungen sollen nachfolgend in diesem Dokument nun als "sortenreine Bondverbindungen" bezeichnet werden. Dabei sind immer Bondverbindungen gemeint, bei denen eine Verbindung zwischen zwei metallischen Kontaktflächen, bestehend aus einem Metall A, ohne Zuhilfenahme von permanent in die Verbindung eingebautes Fremdmaterial, insbesondere eines Fremdmetalls B, welches eine unterschiedliche elementare Zusammensetzung hat, erzeugt wird.

Wie schon oben beschrieben, sind die derzeit vorhandenen Verfahren durch die notwendige Prozesstemperatur, um den Diffusionsprozess zu ermöglichen, begrenzt. Grundsätzlich kann man festhalten, dass Diffusionsprozesse Vorgänge sind, die von einer Vielzahl von Faktoren abhängen. Es ist aber so, dass der Prozess bei niedrigerer Temperatur langsamer abläuft. Dies ist in der Praxis jedoch ein Problem, da dies die Wirtschaftlichkeit von derartigen Prozessen einschränken, beziehungsweise sehr langwierige (>1h) Prozesse unwirtschaftlich machen würde. Daher finden die Diffusionsbonding Prozesse zwischen gleichartigen Kontaktflächen keine Anwendung. Alternativ werden in diesem Fall Lötverbindungen oder verschiedenste Ausprägungen von eutektischen Verbindungen und sogenannten intermetallischen Compound Verbindungen Anwendung verwendet. Als Beispiel seien hier Lötverbindungen auf Basis von Blei/Zinn Lot, von Kupfer-Silber-Zinn Lot, Indium basierenden Loten oder auch Gold-Zinn oder Gold-Silizium oder Aluminium-Germanium, sowie Kupfer-Zinn (Intermetallisches Compound Cu3Sn) angeführt. Der Nachteil dieser Methoden liegt sowohl in fertigungslogistischen Problemstellungen als auch in technologischen Problemstellungen. Vielfach sollen diese Bondverbindungen in einem Bereich der Fertigung hergestellt werden, wo nur eine bestimmte Metallisierung (z.B. Cu) etabliert und qualifiziert ist. In diesem Fall wäre es ein immenser Mehraufwand, zusätzlich zu dieser Metallisierung die Infrastruktur für eine weitere Metallisierung aufzubauen und auch zu qualifizieren. Aus technologischer Hinsicht sind eutektische Verbindungen kritisch hinsichtlich der Langzeitstabilität zu betrachten. Bestimmte Verbindungen sind äußerst spröde und es kann daher unter anderem zu mechanischen Ermüdungserscheinungen kommen. Weiterhin sind für bestimmte Metallisierungen sehr enge Toleranzen hinsichtlich des Mischverhältnisses einzuhalten, um die gewünschten Eigenschaften (z.B. Schmelztemperatur, mechanische und elektrische Eigenschaften) der eutektischen Verbindung zu gewährleisten. Weiterhin können Diffusionseffekte im Zusammenhang mit eutektischen Verbindungen Probleme verursachen. So wäre es zum Beispiel ein gravierendes Problem, wenn Zinn aus einem Interface zwischen zwei Kupfer Kontaktflächen durch den gesamten Kupfer-Kontakt durchdiffundieren und die darunterliegende Grenzschicht zwischen dem Kupfer Kontakt und der darunterliegenden Schicht erreichen würde. Dies würde aufgrund der geänderten Metallkomposition zum mechanischen Delaminieren des Kupfers in diesem Interface führen, und damit einen mechanischen Fehler des Bauteils, der erst nach mehreren Lebensjahren im Feld auftreten könnte, zur Folge haben. Dies sind Effekte, die in dieser Form nur bei Mikrostrukturen auftreten können, da hier sehr dünne Schichten verwendet werden, bei denen derartige Effekte erst eine Rolle spielen können.

Es ist daher die Aufgabe der vorliegenden Erfindung, ein Verfahren anzugeben, mit dem eine reduzierte Prozesstemperatur und/oder eine reduzierte Prozesszeit bei metallischen Bond-Verbindungen erreicht werden kann.

Diese Aufgabe wird mit den Merkmalen des Anspruchs 1 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart und in beliebiger Kombination beanspruchbar sein.

Die vorliegende Erfindung präsentiert nun Methoden und Prozesse, mittels denen die Bondtemperatur für sortenreine Bondverbindungen dramatisch gesenkt werden kann, und die damit den Einsatz von Verbindungen, die ohne Fremdmetall auskommen, für einen breiten Einsatzbereich ermöglicht. Ein Zusatznutzen der vorliegenden Erfindung ist auch die Beschleunigung des Prozesses, die bei ideal gewählten Prozessparametern erreicht werden kann, und die die Wirtschaftlichkeit des Prozesses erhöht.

Diffusion kann allgemein in substitutionelle und interstitielle Diffusion unterteilt werden.

Bei der Substitutionsdiffusion erfolgen die Diffusionssprünge der einzelnen Atome entlang jener Punkte im Gitter, an denen sich andere Atome befinden könnten. Damit ein solcher Diffusionssprung überhaupt erfolgen kann, darf sich an der Position, auf die ein Atom springen möchte aber kein anderes Atom befinden (es existieren Ausnahmen, direkte Atomtauschmechanismen, die wissenschaftlich diskutiert aber noch nicht nachgewiesen sind, wenn sie existieren kommen sie im Vergleich zu anderen Atomtauschmechanismen so selten vor, dass man sie vernachlässigen kann). Man nennt die Position, an der sich kein Atom befindet, eine Leerstelle. Die Leerstelle wird einen fundamental wichtigen Aspekt in der weiteren Patentbeschreibung einnehmen.

Bei der interstitiellen Diffusion diffundieren kleinere Atome innerhalb der Gitterlücken eines Kristalls. Da wir uns in diesem Patent vorwiegend mit homoatomarer Diffusion beschäftigen werden, wird die interstitielle Diffusion nicht weiter betrachtet.

Beispiele für interstitielle Diffusion wäre Wasserstoff, der in die Gitterlücken des Si Kristallgitters diffundiert. Wasserstoff ist im Vergleich zu Si so "klein", das es in den Gitterlücken Platz hat.

Erfindungsgemäß kommt für die Fälle der homoatomaren Diffusion der gleichen Metallspezies nur die Substitutionsdiffusion in Frage.

Des Weiteren kann man zwischen Oberflächen-, Korngrenzen- und Volumendiffusion unterscheiden. Atome diffundieren dort am besten, wo sie von möglichst wenigen anderen Atomen begrenzt sind. Dieser Zustand ist vor allem an der Oberfläche vorhanden, wodurch auch die hohe Mobilität der Atome auf der Oberfläche erklärt wird. Auch in den Korngrenzen hat ein Atom im Allgemeinen mehr Platz als im Kristallgitter selbst. Die Geschwindigkeit der diffundierenden Spezies liegt daher zwischen jener der Oberflächen- und jener der Volumendiffusion. Voraussetzung für eine Korngrenzendiffusion ist natürlich die Existenz von Korngrenzen.

Für den vorliegenden Fall von polykristallinen Metalloberflächen, treten folgende Probleme beim Direktbonden auf.

Erstens bestehen polykristalline Materialien aus mehreren Körnern die relativ zur zu bondenden Oberfläche unterschiedlich orientiert sind. Dies führt dazu, dass die Oberfläche aus unterschiedlichen kristallographischen Oberflächen besteht. Die unterschiedlichen physikalischen Eigenschaften der einzelnen Kornoberflächen haben, im Allgemeinen, unterschiedliche Oxidations-, Diffusions-, Haftungseigenschaften etc.

Zweitens besitzen die Körner sogenannte Korngrenzen, d.h. atomfreie Bereiche im Angström- bis Nanometerbereich, die die Körner voneinander trennen, in denen Atome eine höhere Diffusivität besitzen als im Kornvolumen.

Drittens sind die zu bondenden Oberflächen in den seltensten Fällen frei von Oxidationsprodukten.

Die Tatsache, dass polykristalline Oberflächen, im schlimmsten Fall mit Oxidationsprodukten, und einer von null unterschiedlichen Oberflächenrauigkeit vorliegen, ermöglicht kein direktes Verschweißen. Die Oberflächen werden bei Kontakt nicht vollflächig aufliegen, sondern Poren im Interface bilden. Man verwechsle nicht diese "mikroskopischen Löcher" mit den oben beschriebenen Leerstellen, die für die Diffusion von fundamentaler Bedeutung sind, während "mikroskopische Löcher" im Interface den Sprung von Atomen "zur anderen Seite" verhindern.

Zusammenfassend kann man sagen, dass die Modifizierung zweier Oberflächen erfindungsgemäß so erfolgt, dass bei möglichst niedrigen Temperaturen die Diffusion der Atome ineinander möglichst einfach erfolgen muss.

Die Diffusion kann beispielsweise begünstigt werden, indem die zu verbindenden metallischen Oberflächen so gestaltet werden, dass oberflächennahe Schichten oder idealerweise, eine, von der Oberfläche startende, eine bestimmte Tiefe "d" (Schichtdicke) in das Material reichende Schicht zur Verfügung gestellt wird, die ein Gefüge aufweist, das Diffusion, insbesondere überwiegend Substitutionsdiffusion, zwischen den zu verbindenden Oberflächen bewirkt. Nachfolgend werden nun Methoden beschrieben, die es ermöglichen, diese oberflächennahe Schicht zu erzeugen. Vor allem kann es sich als günstig erweisen, eine oberflächennahe Schicht zur Verfügung zu stellen, die weniger dicht gepackt ist. Damit ist gemeint, dass die Leerstellenkonzentration entsprechend hoch ist. Diese Fehlstellen haben nun den Vorteil, dass bei einer Temperaturbehandlung eine Re-Organisation des Gefüges stattfindet, was letztendlich zu einer dichteren Packung (und einer Eliminierung der Fehlstellen) führt. Wenn nun dieser Temperaturschritt stattfindet, während die beiden metallischen Kontaktflächen in engem Kontakt sind, können diese sich plastisch verformen und damit auch Leerräume im Interface schließen, damit einen noch besseren Kontakt ermöglicht, und die Entstehung eines Diffusionsbonds zwischen diesen beiden Oberflächen begünstigt. Es gibt nun eine Reihe an Varianten für das Bearbeiten der Oberflächen, mit denen diese Schichten erzeugt werden können:

### Nachträgliches Erzeugen von Fehlstellen:

Bei dieser Methode werden die metallischen Kontaktflächen mit Methoden, die aus dem Stand der Technik bekannt sind, hergestellt. Übliche Verfahrensschritte dazu sind die Abscheidung eines sogenannten "Seed Layers", der dazu dient, eine elektrochemische Abscheidung des Metalls (z.B. Kupfer) zu ermöglichen. Die Metallisierung erhält dabei die notwendige Strukturierung (in Kontaktregionen und nichtmetallische, um die Kontaktregionen herum befindliche benachbarte Regionen) mittels Lithographie, und dem Definieren einer sogenannten Plating Maske. Nach dem elektrochemischen Abscheiden des Metalls wird dieses zumeist mittels Chemical Mechanical Polishing (CMP) poliert, um ebene Oberflächen und eine sehr geringe Oberflächenrauigkeit (<2nm, idealerweise <1nm, noch bevorzugter <0,5nm Root-mean-square [rms], gemessen mittels 2x2µm AFM Scan) zu gewährleisten. Diese Verfahren sind in der Industrie hinlänglich bekannt. Je nach Gestaltung des Bond Interfaces kann die, um die Metallpads herumliegende nichtmetallische Region aus Siliziumdioxid oder aus einem organischen Isolatormaterial oder anderen geeigneten Materialien bestehen. Dabei kann die Topographie zwischen den Metallregionen und den umliegenden Regionen entweder so gewählt sein, dass sowohl die Metallregionen, als auch die nichtmetallischen Regionen gleichzeitig in Kontakt kommen - sodass also keine Topographie vorliegt, oder alternativ die nichtmetallischen Regionen gegenüber den metallischen Regionen leicht zurückgesetzt sind (z.B. ca. 100A bevorzugt 1000A oder 2000A), so dass nur die metallischen Regionen miteinander in Kontakt kommen. Alternativ zur elektrochemischen Abscheidung des Metalls kommen auch andere Methoden wie Sputtering oder dgl. in Frage.

Ausgehend von einer, mit weitgehend dem herkömmlichen Diffusionsbondverfahren entsprechenden Oberflächenqualität hergestellten metallischen Kontaktflächen, werden diese nun geeigneten Verfahren unterzogen, um nachträglich Fehlstellen einzubauen.

In einer Ausführungsform werden diese Fehlstellen durch Implantieren von Gasionen erzeugt. Bevorzugterweise werden hierzu Ionen gewählt, die ausreichend Masse besitzen, um Fehlstellen im Gefüge durch "Dislocation" von entsprechenden Metallatomen oder Metallmolekülen zu erzeugen. Als besonders geeignet dafür sind Gase zu betrachten, die mit dem Metall nicht reagieren, insbesondere Edelgase wie Argon. Für bestimmte Anwendungsfälle kommen jedoch auch Stickstoff oder andere Gase mit ausreichend Masse in Frage. Die entscheidende Frage hier ist das Verhältnis der Masse des Gasions im Verhältnis zur Masse des Metallatoms. Dieser Implantationsvorgang kann grundsätzlich in jedem Gerät erzielt werden, welches den Beschuss der metallischen Oberflächen mit Gasionen erlaubt. Bevorzugt wird dies jedoch mit Plasma basierendem System gemacht. Bevorzugt in dieser Kategorie sind sogenannten Inductively Coupled Plasma Systems (ICP) oder sogenannte Capacitively Coupled Plasma Systems (CCP). Bei beiden Systemen und insbesondere ICP Systemen ist es entscheidend, dass die Beschleunigungsenergie für die Ionen richtig gewählt ist, um die gewünschten Eigenschaften der oberflächennahen Metallschicht zu erzielen. Bei ICP Systemen kann diese Beschleunigungsenergie mittels variabler Feldstärke eingestellt werden. Bei CCP Systems kann diese Beschleunigungsenergie mittels einer Reihe von Varianten optimiert werden. Erfindungsgemäß kann hierzu eine Self Bias Voltage auf der Wafer Aufnahme vorgesehen sein, und bevorzugt, diese auch gezielt einzustellen, um die Beschleunigungsenergie der Ionen zu beeinflussen. Noch idealer ist es jedoch, ein sogenanntes Doppelfrequenzplasma ("dual frequency plasma") Setup zu benutzen. Damit ist es möglich, die Plasmadichte und Temperatur mit einer der beiden Frequenzen zu steuern, während die Beschleunigungsenergie mit der zweiten (auf der Waferaufnahme angelegten Frequenz) beeinflussbar ist. Noch idealer funktioniert das Setup, wenn die Frequenz, welche am Wafer angelegt wird vergleichsweise (im Vergleich zu industrieüblichen Plasmasystemen mit 13,56Mhz Betriebsfrequenz) niedrig gewählt ist. Bevorzugterweise ist diese Frequenz kleiner 1Mhz, bessere Ergebnisse werden mit Frequenzen <500kHz, optimale Ergebnisse mit Frequenzen <200kHz und die besten Ergebnisse mit Frequenzen <50kHz erzielt.

Mit einer, insbesondere zusätzlichen, Gleichspannung wird in einer bevorzugten Ausführungsform ein stärkeres elektrisches Feld in einer Grenzschicht (Sheath) bewirkt, wodurch Ionen stärker auf die Substratoberfläche beschleunigt werden.

Besonders gute Ergebnisse werden erzielt, wenn das gewählte Gas für die Plasmaerzeugung nicht nur aus den Ionen zur Erzeugung der Fehlstellen besteht, sondern auch zusätzliche Anteile enthält, die den Prozess günstig beeinflussen. Besonders geeignet ist hier zum Beispiel die Beimengung von Wasserstoff, da Wasserstoff reduzierend wirkt, und so eine Oxidation der Metalloberfläche verhindert, oder sogar eine bereits bestehende Oxidschicht entfernen kann. Insbesondere Wasserstoffionen, die in die Metalloberfläche implantiert sind, können einen nachhaltige oxidationsverhindernde Wirkung aufweisen, die über wenige bis mehrere Minuten (z.B. zumindest 1min, 3min oder 5 bis 10min) andauert. Damit wird ein ausreichendes Zeitfenster zur Verfügung gestellt, um beispielsweise Wafer zueinander auszurichten zu können, und diese anschließend zum Verbonden in eine Bondkammer einbringen zu können. Die Implantation mit verschiedenen Ionen zum erzielen idealer Voraussetzungen kann dabei parallel erfolgen, indem, wie oben beschrieben eine entsprechend gewählte Gasmischung verwendet wird, oder auch sequenziell, indem aufeinanderfolgende Implantierschritte unter Verwendung verschiedener Prozessgase durchgeführt werden. Dies kann entweder in derselben oder in unterschiedlichen Prozesskammern geschehen.

Anschließend an das Erzeugen der Fehlstellen erfolgt das Kontaktieren und Verbonden der Flächen wie bis dato üblich. Es können lediglich die Prozessparameter vorteilhaft angepasst werden. Insbesondere kann das Verbonden nun bei deutlich reduzierter Prozesstemperatur erfolgen. Es können hier exzellente Ergebnisse schon bei Temperaturen <300°C erzielt werden. Bei optimierten oberflächennahen Schichten ist eine Reduktion der Temperatur auf <260°C, idealerweise auf <230°C, in vielen Fällen auf <200°C und in Einzelfällen auch auf <180 oder <160°C möglich. Alternativ kann das Prozessfenster auch so gewählt werden, dass die Prozesszeit bei einer etwas höheren Prozesstemperatur reduziert werden kann.

### Erzeugen einer oberflächennahen Schicht mit Defekten:

Bei entsprechender Wahl der Metallabscheideprozesse ist es möglich, Metallschichten mit minderer Qualität zu erzeugen. Zumeist ist dies unerwünscht, da die elektrische Leitfähigkeit dieser Schichten nur begrenzt ist. Dies ist auf eine sub-optimale Ausgestaltung des Metallgefüges zurückzuführen. Dieser Effekt wird erfindungsgemäß genutzt. Dabei werden zunächst die Metallflächen mit, in der Industrie üblichen Verfahren hergestellt. Hier sei auf die obenstehenden Ausführung verwiesen. Aufbauend auf diese Schichten wird nun eine sehr dünne Metallschicht aufgebracht, die von minderer Qualität ist. Typischerweise wird die Dicke dieser Schicht mit <3nm, besser mit <2nm, noch idealer jedoch mit <1nm oder <0,5nm gewählt. Diese Schicht kann entweder auf beide Kontaktflächen oder alternativ auch auf nur eine der Flächen aufgebracht werden. Dabei werden dann die Dicken entsprechend optimiert. Anschließend werden die Kontaktflächen wie bisher üblich in Kontakt gebracht und erhitzt. Dabei werden nun die Fehlstellen ausgemerzt, und es entsteht an der Kontaktfläche ein Diffusionsbond zwischen den beiden Oberflächen. Die Metallschicht mit der minderwertigen Qualität begünstigt dabei das Entstehen dieses Diffusionsbondes. Die Herstellung dieser Schicht(en) kann über bekannte Prozessparameter an solchen Abscheideprozessen gesteuert werden. Die Parameter, die dabei die Schichtqualität beeinflussen, sind in der Industrie bekannt und in facheinschlägiger Literatur ersichtlich. Zumeist handelt es sich dabei um Abscheidetemperatur, Umgebungsdruck in der Prozesskammer des Abscheidesystems, sowie die Wahl des Gases und der Umgebungsbedingungen, das sich in der Abscheidekammer des Abscheidesystems befindet. Ein dazu geeignetes Verfahren wäre zum Beispiel ein Sputtering Prozess, der unter normalerweise als sub-optimal betrachteten Prozessbedingungen (wie z.B. zu niedrige Prozesstemperatur) durchgeführt wird.

Alternativ kann die Schicht auch mittels Elektroplating hergestellt werden. Es ist dabei denkbar, zuerst die Oberflächen planar herzustellen (wie oben beschrieben), und dann eine dünne Schicht (Schichtdicken siehe oben) mittels Elektroplating herzustellen. Basierend auf einer optimierten Wahl des Elektroplating Prozesses (Chemiezusammensetzung, Stromwerte, Temperatur, etc.) kann damit eine Schicht mit den gewünschten Eigenschaften erzeugt werden.

Fehlstellen im Sinne der vorliegenden Erfindung weisen eine Größe auf, die im Idealfall der Größe eines oder mehrerer Atome aufweist, insbesondere <10nm, vorzugsweise <5nm, noch bevorzugter <3nm, noch bevorzugter <1nm, noch bevorzugter <0,5nm, bezogen auf eine Leerstelle in Kugelform oder einer äquivalenten Form.

### Aufbringen von metallischen Nanopartikeln:

Es ist bereits aus wissenschaftlicher Literatur bekannt, dass Metallpartikel (z.B. Gold, aber auch Kupfer) mit einer Größe von <100nm, idealerweise <70nm, noch besser <50 bis 30nm und bevorzugt <20 oder <10nm die Eigenschaft aufweisen, bei einer Wärmebehandlung bei Temperaturen unter dem Schmelzpunkt je nach Größe der Partikel aber auch weit unter dem Schmelzpunkt, sich zu einem homogenen, kontinuierlichen Metallgefüge zu verbinden. Diese Eigenschaft kann nun für Bondprozesse ausgenutzt werden, indem derartige Partikel in Form einer dünnen Schicht auf eine oder beide metallischen Kontaktflächen aufgebracht werden. Die Kontaktflächen werden anschließend in Kontakt gebracht, und der Wärmebehandlung unterzogen. Während dieser Wärmebehandlung ermöglichen diese Nanopartikel sowohl das Verbonden untereinander als auch das Verbonden mit den metallischen Kontaktflächen und als Endresultat ein vollständiges Verbonden der beiden metallischen Kontaktflächen miteinander. Dies wird dadurch ermöglicht, dass die Nanopartikel sehr reaktiv mit sich selbst sind, als auch die Eigenschaft aufweisen, sich ideal mit Metalloberflächen, insbesondere bestehend aus demselben Metall zu verbinden. Bei Verwendung von kleinen Partikeln kann diese Verbindung bereits bei Temperaturen <250°C, idealerweise <200°C, noch bevorzugter <150°C und in Fällen mit sehr kleinen Partikeln sogar <120°C erfolgen.

### Optimierung der Oberflächenrauigkeit

Eine weitere Möglichkeit, eine ähnliche Beschleunigung des Diffusionsbondes und ein Verbonden insbesondere bei stark reduzierter Temperatur ist es auch, die Oberflächen hinsichtlich Oberflächenrauigkeit entsprechend zu optimieren. Das Grundprinzip besteht in der Planarisierung der Oberflächenwelligkeit und Mikrorauigkeit. Die Root-Mean-Square (RMS) Rauigkeit soll im Nanometer-Bereich liegen. Die eingestellte Rauigkeit muss homogen sein. Das bedeutet, dass die mittlere Wellenlänge, sowie die mittlere Amplitude der Berg-Tal Profile, die man mit einem Atomic-Force-Microscope (AFM) misst, an der gesamten Oberfläche gleich sein müssen. Dies ist eine notwendige Voraussetzung dafür, dass die Oberflächen bei Kontakt so ineinander übergreifen können, dass die Berge der einen Oberfläche die Täler der anderen Oberfläche füllen und vice versa. Aufgrund dieses optimalen Kontaktes wird die Entstehung eines Diffusionsbondes stark begünstigt und auch schon bei niedrigerer Temperatur ermöglicht.

Die dafür erforderliche Oberflächenrauigkeit kann durch gezielt gewählte CMP Prozesse erreicht werden. Zum einen ermöglichen CMP Prozesse das Erzeugen einer sehr ebenen Oberfläche, während mit der geeigneten Auswahl des Slurries auch die Oberflächenrauigkeit beeinflusst werden kann. Das Erzeugen der gewünschten Oberflächenbeschaffenheit kann dabei entweder in einem einzelnen CMP Schritt erfolgen, oder in zwei, aufeinander folgenden Schritten. In diesem Fall dient der erste Schritt dazu, die Planarität der Oberflächen sicherzustellen, während der zweite Schritt dazu dient, die gewünschte lokale Oberflächenrauigkeit herzustellen. Optional kann die Oberflächenrauigkeit auch mittels eines speziellen Ätzschrittes erzeugt werden. Weiterhin ist es denkbar, die geforderte Rauigkeit mit einem Zusammenspiel zwischen Elektroplating und CMP oder als Resultat eines gezielt durchgeführten Elektroplating Schrittes zu erzeugen. Es ist dabei denkbar, zuerst die Oberflächen planar herzustellen, und dann eine dünne Schicht (Schichtdicken siehe Variante Erzeugen einer oberflächennahen Schicht mit Defekten) mittels Elektroplating herzustellen. Basierend auf einer optimierten Wahl des Elektroplating Prozesses (Chemiezusammensetzung, Stromwerte, Temperatur, etc.) kann damit eine Schicht mit den gewünschten Eigenschaften erzeugt werden.

Die Oberflächenrauigkeit (gemessen mit AFM für eine 2x2µm-Fläche) sollte <20nm, insbesondere <10nm, vorzugsweise <5nm, noch bevorzugter <3nm, noch bevorzugter <1nm, noch bevorzugter <0,5nm sein.

Um besonders optimierte Prozessresultate erzielen zu können, können die oben beschriebenen Varianten auch beliebig miteinander kombiniert werden. Vor allem eine Implantierung von Wasserstoff als Maßnahme zur Vermeidung von Oxidation im Zusammenspiel mit den anderen beschriebenen Methoden kann besonders optimierte Ergebnisse liefern.

Es sei hier noch einmal erwähnt, dass das Verfahren auch auf sogenannte "Hybrid Bond Interfaces" angewandt werden kann. Diese Hybrid Interfaces bestehen aus einer geeigneten Kombination von metallischen Kontaktflächen, die von nicht metallischen Regionen umgeben sind. Die nichtmetallischen Regionen sind dabei so gestaltet, dass in einem einzelnen Verbondungsschritt sowohl der metallische Kontakt, als auch Kontakte zwischen den nichtmetallischen Regionen hergestellt werden können.

Hier kann es besonders vorteilhaft sein, den Plasma Implantierschritt so zu gestalten, dass sowohl die metallische Verbindung bei niedriger Temperatur erzeugt werden kann, als auch die Verbindung zwischen den, an die metallischen Regionen angrenzenden nichtmetallischen Bereichen. Diese nichtmetallischen Bereiche könnten dabei aus Siliziumdioxid bestehen, die ebenfalls mittels Plasmabehandlung so modifiziert werden können, dass das Bonden bei sehr niedriger Temperatur stattfinden kann.

Die Erfindung besteht insbesondere in einem Prozessfluss zur Herstellung einer permanenten, elektrisch leitfähigen Verbindung zwischen einer ersten Metalloberfläche eines ersten Substrats und einer zweiten Metalloberfläche eines zweiten Substrats mit folgenden Verfahrensschritten, insbesondere Verfahrensablauf:
- Bearbeitung der ersten und zweiten Metalloberfläche derart, dass bei einer Verbindung der Metalloberflächen, insbesondere in einem Zeitraum von wenigen Minuten nach der Bearbeitung, eine permanente, zumindest überwiegend durch Substitutionsdiffusion zwischen, insbesondere gleichartigen, vorzugsweise gleichen, Metallionen und/oder Metallatomen der beiden Metalloberflächen erzeugte, elektrisch leitfähige Verbindung herstellbar ist,
- Ausrichtung und Verbindung der ersten und zweiten Metalloberfläche, wobei während der Bearbeitung, Ausrichtung und Verbindung eine Prozesstemperatur von maximal 300°C, insbesondere maximal 260°C, vorzugsweise 230°C, noch bevorzugter 200°C, besonders bevorzugt maximal 180°C, idealerweise maximal 160°C, nicht überschritten wird.

## Patentansprüche

1. Verfahren zur Herstellung einer permanenten, elektrisch leitfähigen Verbindung zwischen einer ersten, metallische und nichtmetallische Regionen aufweisenden Oberfläche eines ersten Substrats und einer zweiten, metallische und nichtmetallische Regionen aufweisenden Oberfläche eines zweiten Substrats mit folgenden Verfahrensschritten:
- Bearbeitung der ersten und/oder zweiten Oberfläche derart, dass bei einer Verbindung der Oberflächen eine permanente, zumindest überwiegend durch Substitutionsdiffusion zwischen Metallionen und/oder Metallatomen der metallischen Regionen der Oberflächen erzeugte, elektrisch leitfähige Verbindung hergestellt wird, wobei die Bearbeitung der metallischen Regionen der ersten und zweiten Oberfläche durch Erzeugung oberflächennaher Schichten mit durch Implantieren von Gasionen und/oder Aufbringen von metallischen Nanopartikeln erzeugten Fehlstellen erfolgt,
- Ausrichtung und Verbindung der ersten und zweiten Oberfläche, wobei während der Bearbeitung, Ausrichtung und Verbindung eine Prozesstemperatur von maximal 300°C nicht überschritten wird.

2. Verfahren nach Anspruch 1, **dadurch gekennzeichnet,**
**dass** bei der Verbindung der ersten und zweiten Oberfläche in einem einzelnen Verfahrensschritt auch die nichtmetallischen Regionen in Kontakt gebracht werden.

3. Verfahren nach einem der vorhergehenden Ansprüche,
**dadurch gekennzeichnet,**
**dass** bei der Bearbeitung der ersten und/oder zweiten Oberfläche zusätzlich eine Implantierung von Wasserstoff erfolgt.

4. Verfahren nach einem der vorhergehenden Ansprüche,
**dadurch gekennzeichnet,**
**dass** die nichtmetallischen Regionen aus Siliziumdioxid oder einem organischen Isolatormaterial bestehen.

5. Verfahren nach einem der vorhergehenden Ansprüche,
**dadurch gekennzeichnet,**
**dass** die nichtmetallischen Regionen gegenüber den metallischen Regionen fluchtend oder zurückgesetzt sind.

6. Verfahren nach einem der vorhergehenden Ansprüche,
**dadurch gekennzeichnet,**
**dass** die Bearbeitung das Optimieren der Oberflächenrauigkeit mindestens einer der metallischen Regionen der Oberflächen umfasst.

7. Verfahren nach Anspruch 3, bei dem zum Implantieren von Gasionen Argonionen oder Stickstoffionen verwendet werden, insbesondere in Kombination mit Wasserstoffionen.

## Claims

1. Method for the production of a permanent, electrically conductive connection between a first surface comprising metallic and non-metallic regions of a first substrate and a second surface comprising metallic and non-metallic regions of a second substrate with the following method steps:
- Conditioning of the first and/or second surface in such a way that in a connection of the surfaces a permanent, electrically conductive connection, produced at least primarily by substitution diffusion between metal ions and/or metal atoms of the metallic regions of the surfaces, is produced, wherein the conditioning of the metallic regions of the first and second surfaces is effected by producing near surface layers with surface defects produced by implanting gas ions and/or by application of metallic nanoparticles,
- alignment and bonding of the first and second surfaces, whereby during the conditioning, alignment and bonding, a process temperature of at most 300°C is not exceeded.

2. Method according to Claim 1, wherein during the bonding of the first and second surfaces the non-metallic regions are contacted in a single step.

3. Method according to one of the preceding claims, wherein additionally hydrogen is implanted during conditioning of the first and second metal surfaces.

4. Method according to one of the preceding claims, wherein the non-metallic regions consist of silicon dioxide or an organic insulator.

5. Method according to one of the preceding claims, wherein the non-metallic regions are aligned or recessed with regard to the metallic regions.

6. Method according to one of the preceding claims, wherein the conditioning comprises the optimization of the surface roughness of at least one of the metal surfaces.

7. Method according to claim 3, whereby argon ions and nitrogen ions are used for implanting gas ions, especially in combination with hydrogen ions.

## Revendications

1. Procédé de fabrication d'une liaison permanente conductrice d'électricité entre une première surface présentant des régions métalliques et non-métalliques d'un premier substrat et une seconde surface présentant des régions métalliques et non-métalliques d'un second substrat, comprenant les étapes de procédé suivantes :
- usinage de la première et/ou de la seconde surface de telle façon que lors d'une liaison des surfaces, une liaison permanente, conductrice d'électricité créée au moins majoritairement par diffusion de substitution entre des ions métalliques et/ou des atomes métalliques des régions métalliques des surfaces soit produite, sachant que l'usinage des régions métalliques des première et seconde surfaces est effectué par production de couches proches de la surface avec des manques produits par implantation d'ions gazeux et/ou application de nanoparticules métalliques,
- alignement et liaison des première et seconde surfaces, sachant que pendant l'usinage, l'alignement et la liaison, une température de procédé de 300°C maximum n'est pas dépassée.

2. Procédé selon la revendication 1, **caractérisé en ce que** lors de la liaison des première et seconde surfaces dans une seule étape de procédé, les régions non-métalliques sont également mises en contact.

3. Procédé selon l'une des revendications précédentes, **caractérisé en ce que**
lors de l'usinage des première et/ou seconde surfaces, de l'hydrogène est en outre implanté.

4. Procédé selon l'une des revendications précédentes, **caractérisé en ce que**
les régions non-métalliques sont en dioxyde de silicium ou dans un matériau isolant organique.

5. Procédé selon l'une des revendications précédentes, **caractérisé en ce que**
les régions non-métalliques sont alignées ou en retrait par rapport aux régions métalliques.

6. Procédé selon l'une des revendications précédentes, **caractérisé en ce que**
l'usinage comprend l'optimisation de la rugosité de surface d'au moins une des régions métalliques des surfaces.

7. Procédé selon la revendication 3, dans lequel des ions d'argon ou des ions d'azote sont employés pour implanter des ions gazeux, en particulier en combinaison avec des ions d'hydrogène.
